# EUROPEAN PATENT APPLICATION

(11) **EP 1 300 871 A2**
(43) Date of publication of application: **09.04.2003**
(21) Application number: 02256812.5
(22) Date of filing: 30.09.2002
(51) Int. Cl.: H01J 37/32

(54) **Semiconductor processing apparatus and electrode member therefor**

(30) Priority: 03.10.2001 JP 2001307347; 16.11.2001 JP 2001351711
(71) Applicant: Sumitomo Electric Industries, Ltd., Osaka-shi, Osaka 541-0041 (JP)
(72) Inventor: Natsuhara, M., Itami Works of Sumitomo Elect. Ind., Itami-shi, Hyogo (JP); Nakata, H., Itami Works of Sumitomo Elect. Ind.Ltd, Itami-shi, Hyogo (JP); Kuibira, A., Itami Works of Sumitomo Elect. Ind., Itami-shi, Hyogo (JP)
(74) Representative: Cross, Rupert Edward Blount

(57) **Abstract**

The present invention is directed to a semiconductor processing apparatus having an oxidation-free electrode member for power supply. An electrode member (11) is used for supplying electricity from an external power source to a susceptor (1), which is heated so as to heat a wafer loaded thereon. The electrode member (11) has a thermal expansion coefficient in the range of 3.0 x 10⁻⁶ /K to 8.0 x 10⁻⁶ /K at a temperature from room temperature to 500°C, electric resistance of 10⁻³ Ω cm or less at room temperature. The weight increase due to oxidation is equal to or less than 0.1% / hour at 500°C in the atmosphere.

## Description

### 1. Field of the invention

The present invention relates to a semiconductor processing apparatus, and more specifically to an apparatus for processing semiconductor wafers or liquid crystalline substrates by Plasma-chemical vapor deposition (CVD), Low pressure-CVD, Metal-CVD, Insulation-CVD, Ion injection, Etching etc. The present invention also relates to an electrode member for the apparatus.

### 2. Description of the prior art

In a conventional semiconductor manufacturing process, for example CVD and etching method, a semiconductor wafer is loaded onto a susceptor, and heated by heating the susceptor.

For this purpose, a susceptor has been generally equipped with one or more kinds of heater circuit to heat the wafer, an electrostatic clamping electrode for the susceptor to hold the wafer thereon, and a radio frequency (RF) electrode to generate plasma and so on, at need. Various kinds of structures of electrode members for supplying external electrical power to these electrical circuits have been proposed.

For example, Japanese Patent Laid-Open No. 11-12053 discloses a structure of an electrode using molybdenum as an electrode material.

In addition, in Japanese Patent Laid-Open No. 10-273371, a joint of an electrode and a circuit by means of active metallic solder is disclosed.

However, the technology disclosed in Japanese Patent Laid-Open No. 11-12053 has problems such as the lack of reliability and the reduction of its production yield for the following reason. The technology requires too many soldering places, and insufficient soldering even at one-place results in leakage of atmosphere at the susceptor, which causes an electrode to be oxidized.

In the technology disclosed in Japanese Patent Laid-Open No. 10-273371, if the excess solder ponds at a jointing part between a metallic member and a ceramic, the strength of the joint drops sharply by generating cracks at the ceramic. The difference of thermal expansion coefficient between the ceramic (aluminum nitride) and the solder causes the ceramic to crack after soldering or during heat cycle tests, and finally to be broken at the jointing portion. Thus, the technology lacks reliability.

The present invention provides an electrode member for electric power supply that is superior in anti-oxidation property. (Hereafter "electrode member used for electric power supply" shall be referred to as "electrode member".)

The present invention also provides a semiconductor processing apparatus with such electrode member.

A first aspect of the present invention is directed to an electrode member used for power supply to an electrical circuit buried in a susceptor of a semiconductor processing apparatus, in which a wafer is loaded on the ceramic susceptor for processing. The thermal expansion coefficient of the electrode member is the range of 3.0 x 10⁻⁶/ K to 8.0 x 10⁻⁶/ K at a temperature from room temperature to 500°C. The electric resistance of the electrode member is less than or equal to 10⁻³ Ω cm at room temperature.

Since the thermal expansion coefficients of the sealing glass materials, the electrode member and the susceptor are close to each other in the semiconductor processing apparatus of the present invention, crack generation is effectively prevented.

A second aspect of the present invention is directed to a semiconductor processing apparatus comprising a ceramic susceptor loading a wafer on a surface thereof, wherein an electrical circuit is buried in the susceptor, a hollow is provided on a part of other (rear) surface of the susceptor so as to expose a terminal part of the electrical circuit for connecting to an external power supply, and a washer is inserted in the hollow and connected to the circuit terminal, which functions as a power supply terminal. (Hereafter the "terminal part of the electrical circuit for connecting to an external power supply" shall be referred to as the "circuit terminal".)

An electrode member is provided so as to form a cap to the hollow, and is connected to the washer for supplying electricity.

Glass seal material is spread over an adhering area of an exposed surface of the electrode member and the rear surface of the susceptor in order to prevent the entrance of external air into the hollow. The electrode member is connected to a power supply member so that electricity is supplied to the circuit terminal of the electrical circuit via a power supply terminal such as the washer.

A semiconductor processing apparatus according to the present invention may have a structure in which an electrode member itself inserted in the hollow without using the washer.

Figure 1 is a sectional view of a semiconductor processing apparatus related to Embodiment 1.

Figure 2 is a plan view of a susceptor used for a semiconductor processing apparatus related to Embodiment 1.

Figure 3 is an enlarged view of "A"-part of the apparatus described in Fig. 1 related to Embodiment 1.

Figure 4 is an enlarged view of "A"-part of the apparatus described in Fig. 1 related to Embodiment 2.

Figure 5 is an enlarged view of "A"-part of the apparatus described in Fig. 1 related to Embodiment 3.

Figure 6 is an enlarged view of "A"-part of the apparatus described in Fig. 1 related to Embodiment 4.

Figure 7 is an enlarged view of "A"-part of the apparatus described in Fig. 1 related to Embodiment 5.

Figure 8 is an enlarged view of "A"-part of the apparatus described in Fig. 1 related to Embodiment 6.

### Denotation of Reference Numerals:

1: a susceptor; 2: a wafer; 3: an RF and/or electrostatic clamping electrodes; 4: a hollow; 6: a shaft; 7: a vacuum chamber; 9: a heater circuit; 9a: a circuit terminal; 10: a washer; 11: an electrode member; 12: an anchor member; 13: a power supply member; 14: current flow.

The first aspect of the present invention is related to an electrode member used for supplying power to an electrical circuit that is buried in a ceramic susceptor provided for loading a wafer thereon in a semiconductor processing apparatus for processing the wafer. The electrode member has the properties that a thermal expansion coefficient is in the range of 3.0 x 10⁻⁶ /K to 8.0 x 10⁻⁶ /K at a temperature from room temperature to 500°C and the electric resistance is less than or equal to 10⁻³ Ω cm at room temperature.

Preferably the electrode member is made of a material whose weight increase due to oxidation is less than or equal to 0.1% / hour at 500°C in the air.

In the present invention, the electrode member is made of a material having the properties of anti-oxidation, suitable electric resistance and moderate thermal expansion coefficient to realize good adhesion with a ceramic. Typically the material is selected from the group consisting of titanium boride (TiB₂), silicon carbide-zirconium boride composite, or molybdenum-zirconia composite. The material used for an electrode member may be a tungsten- or molybdenum-based metal or alloy. The surface of the electrode member can be plated with nickel, gold or nickel-gold.

An electrode member of the present invention is adhered to a ceramic susceptor and connected, mechanically or by soldering etc., to a power supply terminal exposed from the ceramic susceptor, wherein the power supply terminal is connected to the electrical circuit via a circuit terminal. Materials of the power supply terminal are normally selected from a group of high melting-point metals, typically metals containing tungsten or molybdenum, in order to meet the thermal expansion coefficient of ceramics.

The electrode member of the present invention is adhered to the ceramic after it is connected with power supply terminals (a washer and/or an anchor member) in order to prevent oxidation of the power supply terminals made of materials containing tungsten or molybdenum. The adhesion of the electrode member to the ceramic is made with the sealing of glass having a thermal expansion coefficient comparatively close to that of the ceramic. If such sealing operation is performed in vacuum or inert gas atmosphere, the power supply terminals are not oxidized.

For this reason it is necessary for the thermal expansion coefficient of the electrode member to be more than or equal to 3.0 x 10⁻⁶ /K at a temperature from room temperature to 500°C. If the thermal expansion coefficient is below the specified value, a crack occurs in glass at a glass sealed portion adhered to the ceramic of the susceptor caused by the difference of thermal expansion coefficients. Resultantly the entrance of external air into places equipped with the electrode members oxidizes the power supply terminals.

When the thermal expansion coefficient of the electrode member is more than 8.0 x 10⁻⁶ /K, a crack also occurs in the glass caused by the difference of thermal expansion coefficient.

Furthermore, the electric resistance of the electrode member must be less than or equal to 10⁻³ Ω cm. If the electrode member has higher electric resistance than the specified value, the electrode member is heated when current flows therethrough into an electrical circuit buried in the susceptor, and thereby the temperature of the susceptor caused to be uneven.

In addition, the weight increase due to the oxidation of the electrode member must be equal to or less than 0.1% / hour at 500°C. If the oxidation rate is faster, the electrode member of the present invention begins to oxidize, since it is used in the air, then weaken, and finally electric current does not flow or such oxidized part is abnormally heated up while the susceptor is used.

The materials suitable for the electrode member having the above-described characteristics are, for example, titanium boride, silicon carbide-zirconium boride composite, or molybdenum-zirconia composite. Their thermal expansion coefficients are from 3 to 8 x 10⁻⁶ /K, and they satisfy the above-described characteristics with respect to electric resistance and weight increase due to oxidation at 500°C.

Other kinds of materials for the electrode member satisfying the above-described characteristics are tungsten- or molybdenum-based metals or alloys, whose surface are plated with nickel, gold or nickel-gold. Tungsten- or molybdenum-based metals or alloys cannot be used as an electrode member as such because an oxidation film is formed on their surface when they are kept in the air at 500°C. However, they can satisfactorily meet the required characteristics if a nickel or gold plating is applied on their surfaces.

Ceramics suitable for forming the susceptor are aluminum nitride, silicon nitride, silicon carbide, and aluminum oxide. Since aluminum oxide is a comparatively low cost material among these, the susceptor can inexpensively be made from it. The susceptors made of aluminum nitride and silicon carbide, which have high thermal conductivity, are advantageous for achieving uniform distribution of temperature when heating is done with heater circuits provided therein. As silicon nitride has high strength, the ceramic material is minimally damaged by heat shock caused by rapid temperature fluctuations.

In addition, since the thermal expansion coefficients of above-mentioned materials for the electrode member are comparatively close to that of ceramics, the electrode material can be directly bonded to the susceptor made of ceramic. Thus, the oxidation of the power supply terminals made of tungsten or molybdenum etc. can be prevented.

Furthermore, plating is possibly applied on the surface of the electrode member if it is made of these materials. For example, plating of nickel, gold, or nickel-gold improves anti-oxidation properties, and also slightly improves electric conductivity.

The second aspect of the present invention relates to a semiconductor processing apparatus having a ceramic susceptor for loading a wafer on a surface thereof, wherein an electrical circuit is buried in the susceptor, a hollow is formed in the other (rear) surface of the susceptor so as to expose a circuit terminal, and a washer is inserted into the hollow. The washer is connected to the circuit terminal, which functions as a power supply terminal. An electrode member is provided to form a cap to the hollow, and is connected to the washer in order to supply electricity. Glass seal material is spread over an adhering area of an exposed surface of the electrode member and the rear surface of the susceptor in order to prevent the entrance of external air into the hollow. A power supply member is connected to the electrode member so as to supply electricity to the electrical circuit through the electrode member, the washer and the circuit terminal.

Preferably an anchor member is further provided in the hollow such that one end thereof is fixed to the bottom of the hollow, and the other end thereof is fastened by a screw into the electrode member through the washer.

According to another preferred embodiment of the present invention, the electrode member includes a cup-shaped wall portion whose concave surface caps the hollow of the susceptor so as to seal off the washer and the anchor member from the external air.

In another preferred embodiment of the present invention, a step is provided in the wall portion of the hollow of the susceptor so as to receive the end of the wall portion of the electrode member.

In another preferred embodiment of the present invention, the other end of the anchor member is fixed to the bottom of the hollow by glass sealing.

In other preferred embodiment of the present invention, the other end of the anchor member is fixed to the bottom of the hollow the susceptor by a screw fastener.

A semiconductor processing apparatus according to a third aspect of the present invention comprises a ceramic susceptor for loading a wafer on a surface thereof, wherein an electrical circuit is buried in the susceptor, a hollow is provided on the other (rear) surface of the susceptor so as to expose a circuit terminal such that an electrode member is inserted in the hollow and the circuit terminal is electrically connected with the electrode member so as to receive power supplied therethrough from an external source. In addition, glass seal material is provided onto an exposed surface of the electrode member and the rear surface of the susceptor in order to prevent the entrance of external air into the hollow. A washer is omitted in this type.

The electrode member is connected to a power supply member so that electricity is supplied to the electrical circuit via the electrode member and the circuit terminal.

Preferably an anchor member, as a power supply terminal, is provided in the hollow of the electrode member such that an end of the anchor member is fastened by a screw into the electrode member and the other end of the anchor member is fixed to the bottom of the hollow.

Another preferable embodiment is that the electrode member has a thermal expansion coefficient in the range of 3.0 x 10⁻⁶ /K to 8.0 x 10⁻⁶ /K at a temperature from room temperature to 500°C, an electric resistance of less than or equal to 10⁻³ Ωcm at room temperature, and a weight increase due to oxidation of less than or equal to 0.1% / hour at 500°C in the air.

In a preferable embodiment of the present invention, the electrical circuit may be any of a heater circuit, a high frequency electrode and an electrostatic clamping electrode.

Preferred embodiments are explained with reference to the accompanying figures as follows:

### Embodiment 1

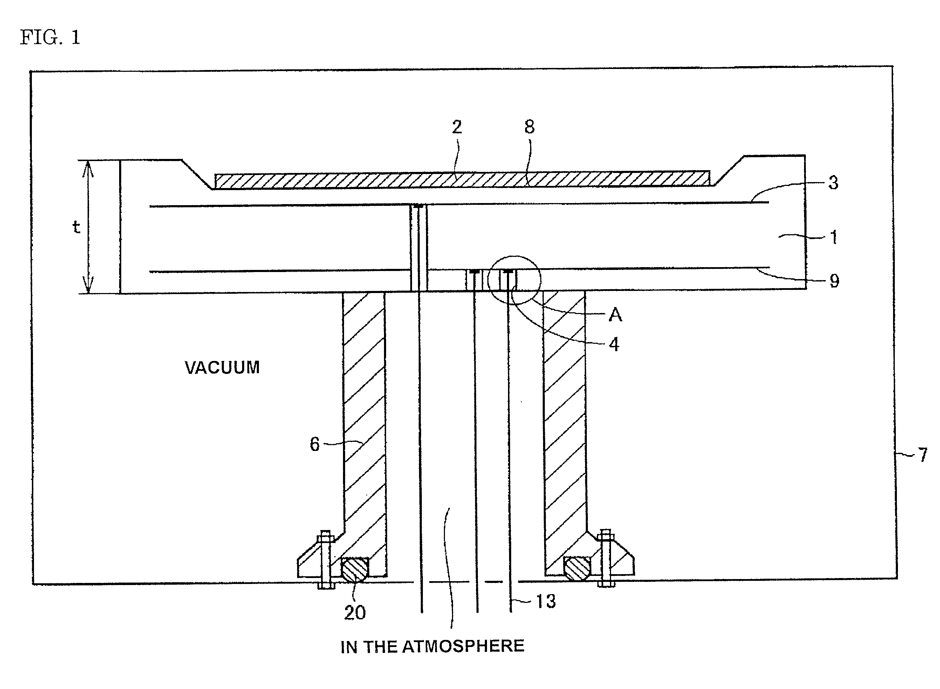

Figure 1 is a schematic cross-sectional view of a semiconductor processing apparatus that is related to Embodiment 1.

The semiconductor processing apparatus comprises a susceptor (1) made of ceramic, wherein an RF and/or electrostatic clamping electrode (3) and electrical circuits such as a heater circuit (9) are buried in the susceptor (1) and a wafer (2) is loaded on a surface of the susceptor (1).

A hollow (4) is provided in the other (rear) surface of the susceptor so as to expose a circuit terminal for the connection to an external power supply. A power supply member (13) is connected to the electrical circuit via the hollow (4). The susceptor (1) is supported by a shaft (6) with an O-ring (20) to the bottom portion of a vacuum chamber (7). The thickness (t) of the susceptor (1), for example, is 3-20mm. The inside of the vacuum chamber (7) is normally vacuum, and the inside of the shaft (6) is exposed to the outer atmosphere.

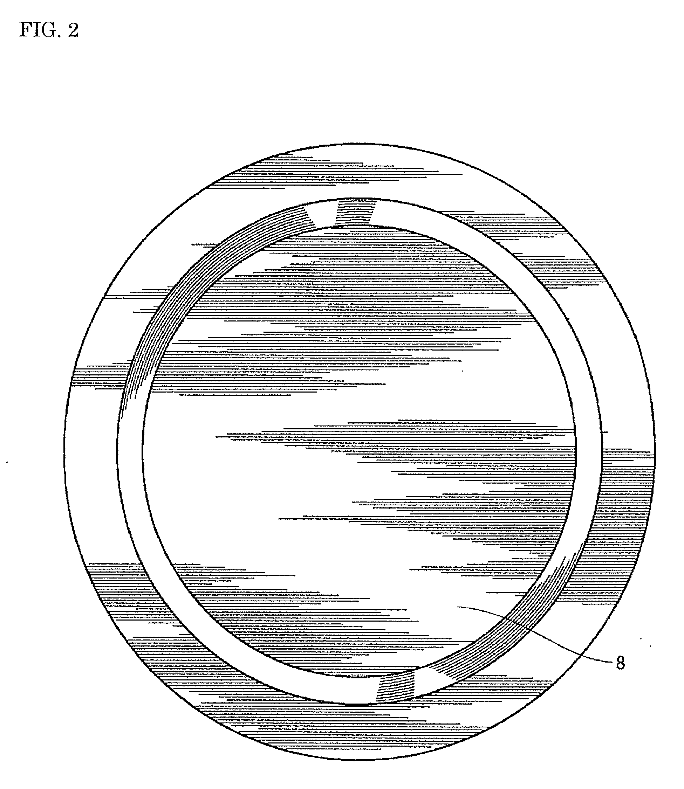

Figure 2 is a plan view of the susceptor (1). The wafer (2) is loaded on a depressed part (8) of a surface of the susceptor (1). The wafer (2) is clamped at the depressed part (8) by electrostatic force.

The shaft (6) is usually made of the same material as the susceptor (1), for example, aluminum nitride, aluminum oxide or silicon carbide.

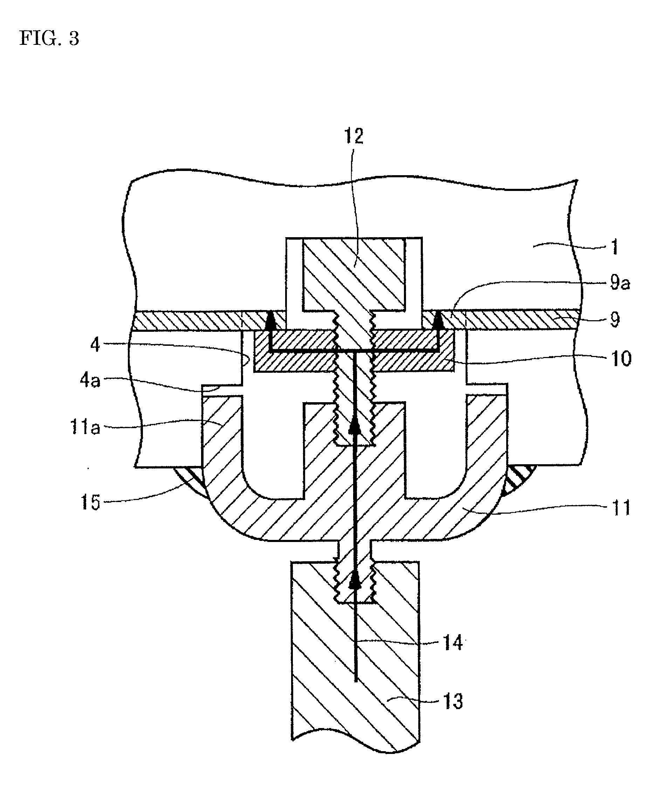

The detailed structure of the power supply member (13) and a connecting part of the electrical circuit is explained by using, for example, Fig. 3 which is an enlarged view for the "A"-part shown in Fig. 1.

Referring to Fig. 3, the hollow (4) is provided to expose a circuit terminal (9a) of the heater circuit (9) at the rear surface of the susceptor (1). A washer (10), which functions as a power supply terminal, is inserted into the hollow (4), and connected to the circuit terminal of the heater circuit (9). An electrode member (11), which is provided so as to cap the hollow (4), is electrically connected to the washer (10) through an anchor member (12).

An end of the anchor member (12) fastened by a screw into the washer (10) is further fastened by a screw into the electrode member (11), and the other end of the anchor member (12) is fixed to the bottom of the hollow (4). Fixation of the other end of the anchor member (12) with the bottom of the hollow (4) is described below.

The electrode member (11) having a cup-shaped wall portion (11a) faces the hollow (4) of the susceptor (1) as described above. The cup-shaped wall portion (11a) is capped to the hollow (4) of the susceptor (1) in order to prevent the atmosphere from entering into the hollow such that the washer (10) and the anchor member (12) are sealed off. A step (4a) is provided to receive an edge of the wall portion (11a) in the hollow (4) of the susceptor (1). The electrode member (11) is fastened by a screw into the power supply member (13).

Sealing glass (15) is spread over an adhering area of an exposed surface of the electrode member (11) and a part of the rear surface of the susceptor (1) in order to prevent the entrance of the atmosphere into the hollow (4). Electric power is supplied to the heater circuit from the power supply member (13) through the electrode member (11) the washer (10) and the circuit terminal (9a). The arrow in the figure shows an electric current flow.

The electrode member has a thermal expansion coefficient in the range of 3.0 x 10⁻⁶ /K to 8.0 x 10⁻⁶ /K at a temperature from room temperature to 500°C. When the thermal expansion coefficient is out of the above specified range, the difference of a thermal expansion coefficient between the ceramic and the sealing glass (Thermal expansion coefficient of glass: 3.0 - 8.00 x 10⁻⁶ /K) leads to deformation such as the occurrence of a crack in the sealing portion. The crack allows the ambient atmosphere to enter into the hollow area where the electrode member (11) is provided, and thereby the power supply terminals (10) and (12) are oxidized.

The electrode member (11) is made of a material whose electric resistance is less than or equal to 10⁻³ Ωcm at room temperature. If the electric resistance is higher than the above-mentioned value, the uniformity in the temperature distribution of the susceptor (1) is adversely affected by heat generated in the electrode member (11) when an electric current flows through the member (11) to the electrical circuit (9).

In addition, the electrode member (11) is selected from the materials whose weight increase by the oxidation is less than or equal to 0.1% / hour at 500°C. in the atmosphere. If the oxidation rate is faster than the above number, the electrode member (11) begins to be oxidized and weakened during the use of the susceptor because the electrode member of the present invention is used in the atmosphere.

Typically the main composition of the electrode member (11) is at least one material selected from the group consisting of titanium boride, silicon carbide-zirconium boride composite, and molybdenum-zirconia composite.

Further, the electrode member (11) may be made of a metal or alloy which includes tungsten or molybdenum as a main composition thereof and whose surface is plated with nickel, gold, or nickel-gold.

The main composition of the ceramic for the susceptor (1) is selected the group consisting of aluminum nitride, silicon nitride, silicon carbide, and aluminum oxide.

The selection of these materials is based on the following sequential consideration:
1. Select a sealing glass material having a thermal expansion coefficient fitting for that of a susceptor.
2. Select an electrode member fitting for the thermal expansion coefficient of the sealing glass.
In other words, by means of selecting the thermal expansion coefficients of electrode member (11), the susceptor (1) and the sealing glass materials (15) so as to be close to each other, crack generation can be prevented.

### Embodiment 2

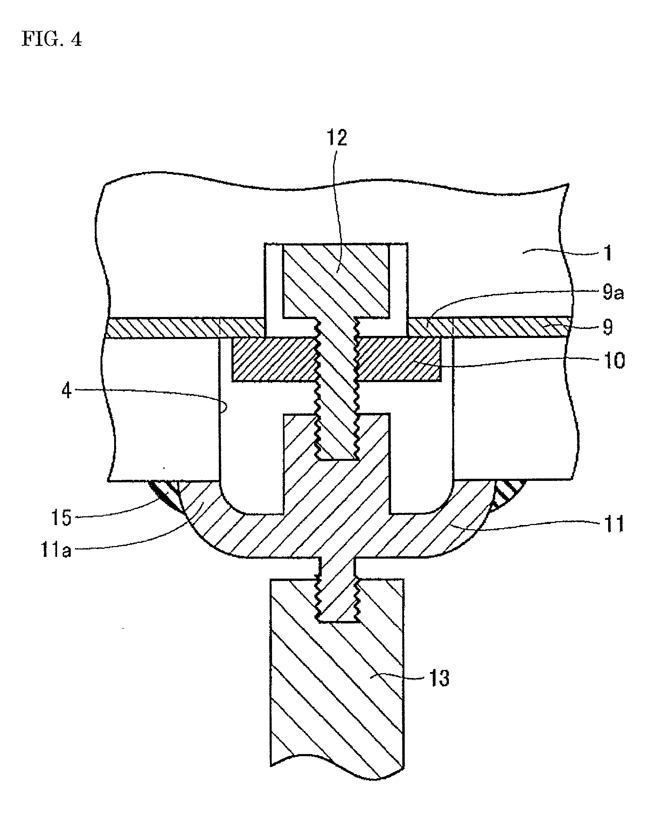

Figure 4 shows another type of the "A"-part of the semiconductor processing apparatus shown in Fig. 1, which is related to Embodiment 2.

Reference numbers in Fig. 4 are the same as the numbers denoted in Fig. 3 and the explanation thereof is not repeated. The same applies to reference numbers in the figures illustrating Embodiments 3 through 6.

In the above-described example in Embodiment 1, the step is provided in the wall of the hollow of the susceptor so as to receive the edge of the wall portion (11a). However, the present invention is not limited to the embodiment. In other words, as shown in Fig. 4, the edge of the wall portion (11a) may be adhered to the rear surface of the susceptor (1) without providing any steps.

### Embodiment 3

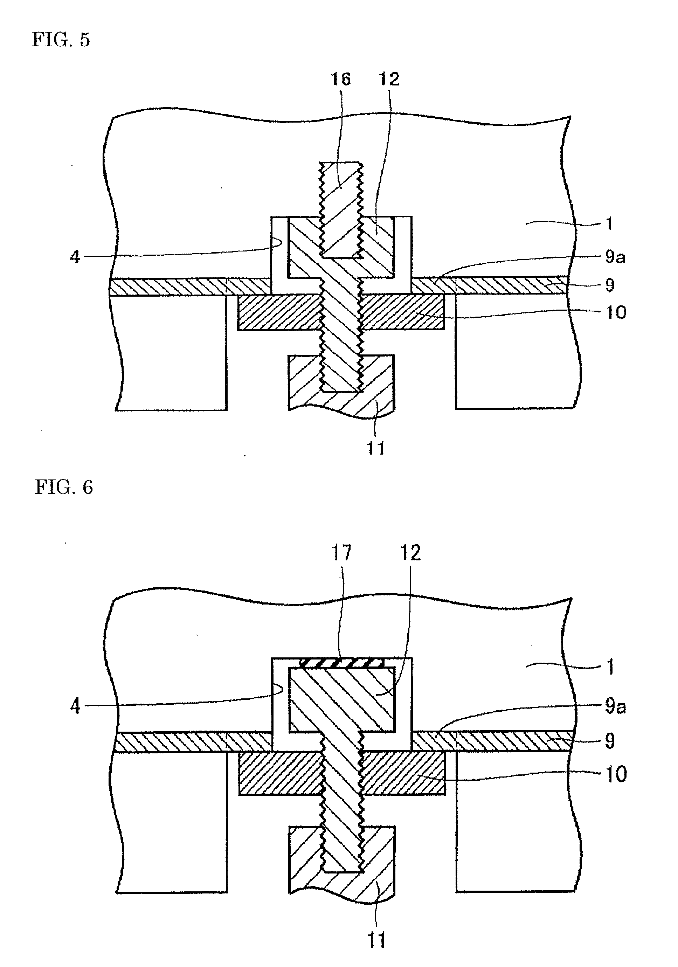

Figure 5 is a sectional view of the "A"-part of the semiconductor processing apparatus shown in Fig. 1, which is related to Embodiment 3. An end of an anchor member (12) is fixed to the bottom of a hollow (4) by means of a screw fastener (16). This embodiment shows the same effect as Embodiment 1.

### Embodiment 4

Figure 6 is a sectional view of the "A"-part of the semiconductor processing apparatus shown in Fig. 1, which is related to Embodiment 4. An end of an anchor member (12) is fixed to the bottom of a hollow (4) by means of glass sealing (17). This embodiment also shows the same effect as Embodiment 1.

### Embodiment 5

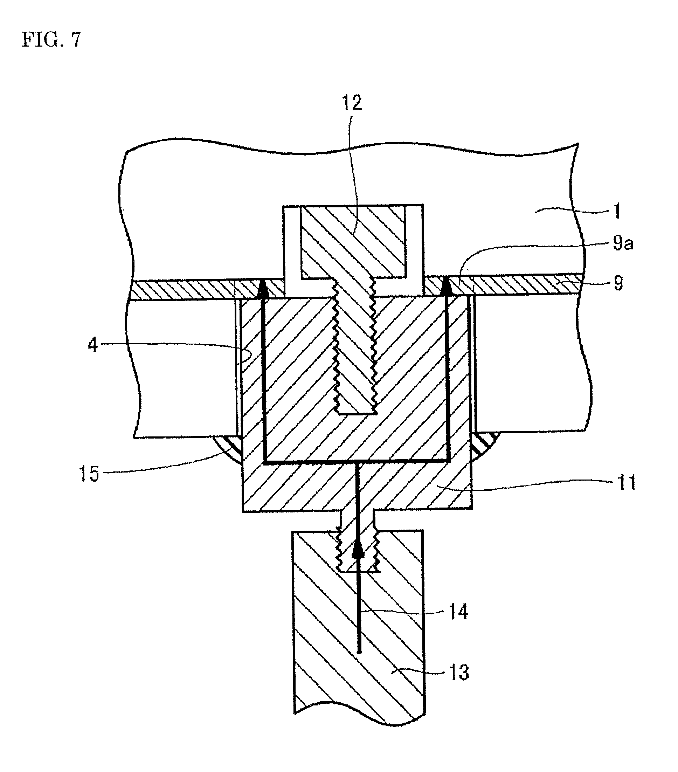

Figure 7 is an enlarged view of the "A"-part of the semiconductor processing apparatus shown in Fig. 1, which is related to Embodiment 5.

Referring to Fig. 7, an electrode member (11) is inserted into a hollow (4). The electrode member (11) is electrically connected directly to a circuit terminal (9a) of a heater circuit (9). In other words, the washer (10) used in Fig. 3 is omitted in this embodiment. Sealing glass (15) is provided on an exposed surface of the electrode member (11) and other (rear) surface of the susceptor (1) in order to prevent the entrance of the atmosphere into the hollow (4). The electrode member (11) is connected to a power supply member (13). Electricity is directly supplied to the heater circuit (9) from the power supply member (13) through the electrode member (11). The embodiment shows the same effect as in Embodiment 1.

### Embodiment 6

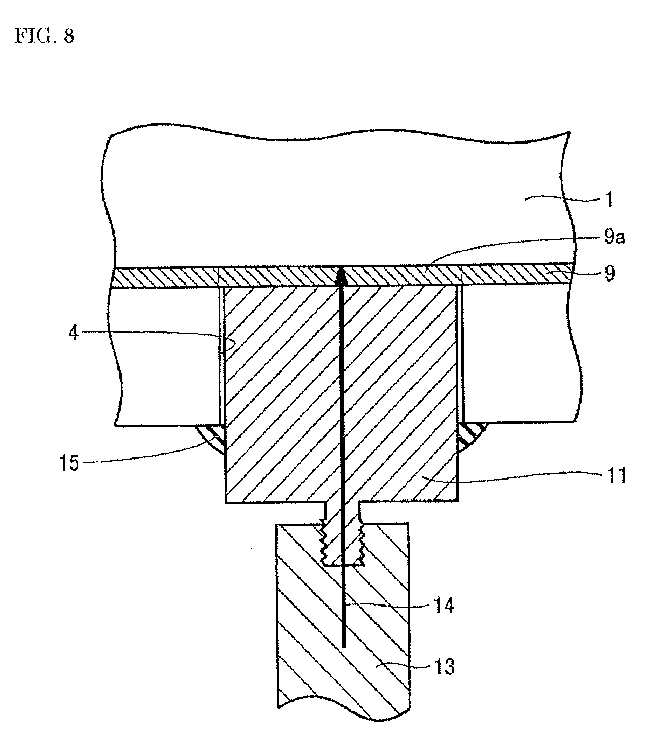

Figure 8 is an enlarged view of the "A"-part of the semiconductor processing apparatus shown in Fig. 1, which is related to Embodiment 6.

This embodiment dispenses with an anchor member (12), which is used in Embodiment 5. Electricity is supplied to the heating circuit (9) by the power supply member (13) through the electrode member (11). This embodiment also shows the same effect as in Embodiment 1.

### Experimental results of the present invention are explained as follows:

### 1. Experiment 1

First, a production method of ceramic used for the present invention is explained.

Slurries were made from powders having the following compositions by adding a binder and solvent and mixing them by means of a ball-mill, respectively.
Composition 1... AlN: 95 wt% - Y₂O₃: 5 wt%
Composition 2... Si₃N₄: 95 wt% - Y₂O₃: 2.5 wt% - Al₂O₃: 2.5 wt%
Composition 3... Al₂O₃: 98 wt% - CaO: 1.0 wt% - MgO: 1.0 wt%
Composition 4... SiC: 98 wt% - B2O3: 2.0 wt %

A green sheet was made from each of the slurries by the doctor blade method. Then each sheet was cut to produce a circular shape so as to have a diameter of 350mm after sintering. An electrical circuit for heating was formed with a tungsten paste on the circular sheet by a screen-printing method. (Hereafter "electrical circuit for heating" shall be referred to as "heater circuit".)

Plural circular shaped sheets having no electrical circuit were laminated on the circuit-printed sheet. Then an RF and/or electrostatic clamping electrodes were formed on the laminated sheet with a tungsten paste by the screen printing method, after which the electrode printed sheet was defatted at 700°C in nitrogen gas.

Each of these formed sheets having Composition 1, 2, 3, or 4 was sintered to form susceptors at 1800°C, 1700°C, 1600°C, or 2000°C in nitrogen atmosphere, respectively.

Next, granules were made from slurries by the spray-dry method, each having Composition 1 to 4. Cylindrical bodies were formed from each of the granules by the dry-press method. These cylindrical bodies were defatted in nitrogen gas flow at 700°C, and then sintered under the same conditions as the sintering of the formed sheets. The sintered cylindrical bodies were processed by machining into tubular bodies having a 50mm inner diameter, 60mm outer diameter, and 200mm length. Each of these tubular bodies was used as a shaft (6) shown in Fig. 1.

Referring to Fig. 1, one end of the shaft (6) was pasted with a slurry of Al₂O₃-Y₂O₃-AlN and adhered to the susceptor (1), and the shaft (6) and the susceptor (1) were joined together under the same conditions as the sintering of the formed sheets. At the same time, the heater circuit (9) and power supply terminals (10), (11), and (12) for receiving power from an external source and supplying it to an RF and/or electrostatic clamping electrodes (3) were all arranged so as to be equipped inside the shaft (6).

A tungsten or molybdenum washer as a power supply terminal (10) was connected to the heater circuit (9) with an active metal solder containing titanium. An electrode member (11) made of titanium boride, silicon carbide-zirconium boride composite, or molybdenum-zirconia composite was fixed, and then sealed with glass (15). A power supply member (13) made of nickel was fixed to the electrode member afterwards, completing the production of the susceptor (1).

In this case, the power supply terminal (10), the electrode member (11), and the power supply member (13) were mechanically connected by means of screw fasteners, respectively. After setting the completed susceptor (1) in a chamber (7), an experiment was carried out by forming a film on a silicon wafer (2). The experiment was carried out under the condition in which the susceptor (1) has a temperature at 500°C and the atmosphere inside the shaft (6) was air. All of the silicon wafers (2) were successfully processed with no problems in any of the electrode members. However, a thin oxidation film was formed on each of the power supply terminals (10) and the electrode members (11).

### Experiment 2

Other susceptors (1) were made by the same method as Experiment 1 except that all electrode members were plated with nickel, gold, or nickel-gold respectively. All of silicon wafers (2) were successfully processed with no problems in any of power supply terminals (10) and the electrode members. And no thin oxidation film was formed on any of the power supply terminals and the electrode members.

### Experiment 3

Other susceptors (1) were made by the same method as Experiment 1 except that all electrode members were made from tungsten (W) or molybdenum (Mo) with nickel-, gold-, or nickel-gold-plating. Table 1 shows the detailed experimental conditions.

**Table 1**

| Material of Electrode Member | Thickness of Nickel-Plating (Micrometers) | Thickness of Gold-Plating (Micrometers) |
|---|---|---|
| W | 2.0 | None |
| W | None | 2.0 |
| W | 2.0 | 2.0 |
| Mo | 2.0 | None |
| Mo | None | 2.0 |
| Mo | 2.0 | 2.0 |

All of the silicon wafers were successfully processed the same as Experiment 2 with no problems in any of power supply terminals and electrode members.

### Comparative Experiment 1

Susceptors (1) were made by the same method as Experiment 1 except that all electrode members were made from tungsten or nickel. In this case, silicon wafers could not be processed satisfactorily because the oxidation of the tungsten electrode members occurred during heating-up of the susceptor. In the case of using a nickel-made electrode, cracks occurred in the glass during a sealing process. Consequently, the silicon wafers also could not be processed satisfactorily, because the oxidation of the power supply terminals made of tungsten occurred.

A heater circuit was described as an electrical circuit in the above experiments; however, the electrical circuit such as a high frequency electrode or an electrostatic clamping electrode shows the similar results.

The embodiments and experiments disclosed above are examples of the present invention, and the present invention shall not be considered to be limited in the specification. The range of the present invention shall not be considered to limit them.

## Claims

1. An electrode member for supplying electricity to an electrical circuit buried in a susceptor made of ceramic in a semiconductor processing apparatus wherein
the electrode member has a thermal expansion coefficient in the range of 3.0 x 10⁻⁶ /K to 8.0 x 10⁻⁶ /K at a temperature from room temperature to 500°C, and
the electrode member has an electric resistance less than or equal to 10⁻³ Ωcm at room temperature.

2. An electrode member according to claim 1, wherein
the electrode member is made of a material whose weight increase due to oxidation is less than or equal to 0.1% / hour at 500°C in the atmosphere.

3. An electrode member according to claim 2, wherein
the main composition of the electrode member is at least one material selected from the group consisting of titanium boride, silicon carbide-zirconium boride composite, and molybdenum-zirconia composite.

4. An electrode member according to claim 2, wherein
the main composition of the electrode member is tungsten or molybdenum or an alloy thereof, and
a surface of the member is plated with nickel, gold, or nickel-gold.

5. An electrode member according to any one of claims 1 to 4, wherein
the main composition of the ceramic is a material selected from the group consisting of aluminum nitride, silicon nitride, silicon carbide, and aluminum oxide.

6. An electrode member according to claim 3, wherein
the electrode member is plated.

7. A semiconductor processing apparatus comprising:
a ceramic susceptor for loading a wafer on a surface thereof,
an electrical circuit buried in the susceptor,
a hollow provided on rear surface of the susceptor so as to expose a connecting terminal of the electrical circuit for receiving power supplied from an external power source,
a washer inserted in the hollow as a supply terminal to connect with the connecting terminal,
an electrode member provided so as to cap the hollow and to electrically connect to the washer,
glass seal material spread over an adhering area of an exposed surface of the electrode member and the rear surface of the susceptor in order to prevent the entrance of external air into the hollow, and
a power supply member connected with the electrode member, wherein electricity is supplied through the power supply member and the electrode member to the electrical circuit.

8. A semiconductor processing apparatus according to claim 7, wherein
an anchor member is provided in the hollow such that an end of the anchor member is fastened by a screw into the electrode member through the washer, and the other end of the anchor member is fixed to the bottom of the hollow.

9. A semiconductor processing apparatus according to claim 8, wherein
the electrode member includes a cup-shaped wall portion whose concave surface caps the hollow of the susceptor so as to seal the washer and the anchor member from the external air.

10. A semiconductor processing apparatus according to claim 9, wherein
a step to receive an edge of the wall portion is provided in the wall of the hollow.

11. A semiconductor processing apparatus according to claim 9, wherein
fixing of the anchor member to the bottom of the hollow is made by glass sealing.

12. A semiconductor processing apparatus according to claim 9, wherein
fixing of the anchor member to the bottom of the hollow is made by a screw fastener.

13. A semiconductor processing apparatus comprising:
a ceramic susceptor for loading a wafer on a surface thereof,
an electrical circuit buried in the susceptor,
a hollow provided on rear surface of the susceptor so as to expose a connecting terminal of the electrical circuit for receiving power supplied from an external power source,
an electrode member inserted in the hollow and electrically connected to the connecting terminal,
glass seal material spread over an adhering area of an exposed surface of the electrode member and the rear surface of the susceptor so as to prevent the entrance of external air into the hollow, and
a power supply member connected with the electrode member, wherein electricity is supplied through the power supply member, the electrode member and to the electrical circuit.

14. A semiconductor processing apparatus according to claim 13, wherein
an anchor member is provided in the hollow such that an end of the anchor member is fastened by a screw into the electrode member and the other end of the anchor member is fixed to the bottom of the hollow.

15. A semiconductor processing apparatus according to claim 7 or 13, wherein the electrode member has an electric resistance of 10⁻³ Ωcm or less at room temperature, and a thermal expansion coefficient in the range of 3.0 x 10⁻⁶ /K to 8.0 x 10⁻⁶ /K at a temperature from room temperature to 500°C, and
the electrode member is made of a material whose weight increase due to oxidation is less than or equal to 0.1% / hour at 500°C in the atmosphere.

16. A semiconductor processing apparatus according to claim 7 or 13, wherein
the electrical circuit is at least one selected from the group of a heater circuit, a high frequency electrode and an electrostatic clamping electrode.
